# DEMANDE DE BREVET EUROPEEN

(11) **EP 2 874 182 A1**
(43) Date de publication de la demande: **20.05.2015**
(21) Numéro de dépôt: 13306583.9
(22) Date de dépôt: 19.11.2013
(51) Int. Cl.: H01L 21/56

(54) **Procédé de fabrication de dispositifs électroniques**

(71) Demandeur: Gemalto SA, 92190 Meudon (FR)
(72) Inventeur: Ottobon, Stéphane, 13705 LA CIOTAT (FR); Dossetto, Lucile, 13705 LA CIOTAT (FR); Audouard, Laurent, 13705 LA CIOTAT (FR); Guijarro, Sébastien, 13705 LA CIOTAT (FR)

(57) **Abrégé**

L'invention porte sur un procédé de fabrication d'un dispositif électronique (1) comprenant au moins un composant électronique (2), ledit procédé comprenant au moins une étape de report dudit composant électronique (2) sur une face (9) d'un support diélectrique (5) amovible, et étant caractérisé en ce qu'il comprend en outre les étapes suivantes :
- dispense d'une résine de protection (7) sur ledit composant électronique,
- report, sur la résine de protection (7), d'une pastille (10) de renfort dont la surface délimite le contour final dudit dispositif électronique (1), la résine de protection (7) se répartissant, sous l'action du poids de la pastille (10), jusqu'audit contour dudit dispositif électronique (1) pour former ses bords latéraux et lui conférer son épaisseur finale.

## Description

### [Domaine de l'invention]

L'invention porte sur un dispositif électronique comprenant au moins un composant électronique électriquement connecté à une interface de communication.

L'invention concerne plus particulièrement un procédé de fabrication d'un tel dispositif électronique ainsi que le dispositif électronique obtenu. L'invention porte en outre sur un support de conditionnement d'une pluralité de dispositifs électroniques ainsi fabriqués.

On peut trouver de tels dispositifs électroniques par exemple sous la forme de cartes, aux facteurs de forme divers tels que ceux de petits objets électroniques de formats micro-SD (acronyme anglais pour « *Secure Digital»),* Micro-SIM (acronyme anglais pour *« Subscriber Identity Module* ») ou Plug-in SIM, Mini UICC (acronyme anglais pour « *Universal Integrated Circuit Card* »). On peut trouver en outre toute une gamme de dispositifs se présentant sous forme de boîtiers, permettant le montage de composants en surface (noté CMS en français ou SMD en anglais pour « Surface Mounted Device »), ainsi que des boîtiers de type BGA (acronyme anglais pour « *Ball Grid Array* ») comportant des billes de connexion. Ces boîtiers comprennent une interface d'alimentation et/ou de communication notamment à contacts électriques ou à antenne.

L'invention concerne plus particulièrement, mais de manière non limitative, la fabrication de dispositifs électroniques portables sécurisés comme des cartes ou modules à puce qui trouvent notamment leurs applications dans la santé, la banque, les télécommunications ou encore le contrôle d'identité, le contrôle d'accès physique et/ou logique.

### [Art antérieur]

Les techniques connues pour fabriquer de tels objets nécessitent un procédé parfois lent, complexe et peu adaptable. Il faut généralement fabriquer dans un premier temps un module électronique qui est ensuite inséré dans le corps d'un boîtier pour former le dispositif électronique. La fabrication d'un dispositif électronique comprenant au moins une puce de circuit intégré et/ou un composant électronique, comprend principalement les étapes suivantes:
- définition d'un rouleau de circuit imprimé spécifique ;
- découpe mécanique dudit circuit imprimé ou gravure chimique pour définir une forme de contacts ;
- découpe dans un diélectrique pour créer des puits de connexion ;
- contre-collage du diélectrique sur le circuit imprimé ;
- métallisation des plots de contacts ;
- collage d'une ou plusieurs puces d'épaisseurs variables ;
- câblage à l'aide de fils pour interconnecter lesdites puces aux plots de contact ;
- enrobage des puce(s) et connexions dans une résine de protection,
- laminage d'un adhésif sur la bande de modules ainsi fabriqués puis découpe et insertion de chaque module dans un corps de boitier pour former un dispositif électronique.

Le document EP1 780 662 décrit en outre la possibilité d'enrober la puce et ses connexions dans un moule dans lequel une pastille de renfort est disposée préalablement à l'étape de moulage de la résine d'enrobage. Une telle pastille de renfort permet de protéger mécaniquement le module électronique.

Le module électronique ainsi réalisé est ensuite encarté dans le corps d'un boîtier pour former un dispositif électronique. Pour cela, le module est reporté dans une cavité ménagée dans le corps du boitier. Une alternative consiste à placer le module au fond d'un moule dans lequel le matériau de constitution du corps du boîtier est surmoulé au format final du dispositif électronique.

Une dernière étape consiste ensuite à séparer les boitiers moulés ou surmoulés, par découpe à l'aide de tout type de procédé de découpe (sciage mécanique, poinçonnage, laser, jet d'eau).

Le document FR2 833 736 décrit en outre un procédé de surmoulage d'un boîtier sur un support papier amovible. Une fois le boitier surmoulé, une étape ultérieure consiste à usiner une cavité dans le boitier pour y reporter un module électronique et ainsi obtenir une carte à puce. La carte à puce ainsi obtenue est ensuite séparée de son support papier amovible.

Les procédés existants nécessitent donc de nombreuses étapes qui contribuent à l'obtention d'un coût de fabrication élevé.

D'autre part, pour permettre une plus grande intégration dans les appareils portatifs, tels que les téléphones par exemple, les exigences en termes de réduction d'épaisseur et d'encombrement des dispositifs électroniques sont de plus en plus fortes. Ainsi, par exemple, la carte nano-SIM, encore notée sous le sigle 4FF, dont l'épaisseur est normalisée à 0,67mm, doit présenter une épaisseur réduite de 11 % par rapport à la carte micro-SIM, notée sous le sigle 3FF. C'est pourquoi, il devient également important de trouver des solutions pour optimiser les procédés de fabrication, afin de tenir compte de ces exigences et permettre l'obtention de dispositifs électroniques d'épaisseur et d'encombrement réduits.

La demande de brevet EP 12306128.5 déposée le 18 septembre 2012 non encore publiée, décrit un procédé simplifié de fabrication d'un dispositif électronique consistant à réaliser un jeu de métallisations conductrices sur un support amovible, à reporter et connecter une puce de circuit intégré au jeu de métallisations, puis à surmouler le corps du dispositif au-dessus de la puce et des métallisations conductrices, de sorte que les métallisations conductrices sont transférées dans la résine de surmoulage au moment de la séparation du support amovible.

Cependant, la demanderesse a cherché à simplifier encore plus ce procédé pour optimiser encore les coûts de fabrication et réduire encore l'épaisseur du dispositif électronique.

### [Problème technique]

L'invention a donc pour but de remédier à au moins un des inconvénients de l'art antérieur. En particulier, l'invention vise à proposer un procédé de fabrication d'un dispositif électronique qui soit rapide et simple à mettre en oeuvre, avec un minimum d'étapes, afin de diminuer les coûts fabrication. L'invention vise également à réaliser des dispositifs électroniques qui présentent un faible encombrement, et notamment une épaisseur réduite par rapport aux dispositifs existants, afin de les rendre compatibles avec des nouveaux formats et de faciliter leur intégration dans les appareils portatifs.

### [Résumé de l'invention]

Le principe de l'invention repose sur un assemblage spécifique comprenant la dispense d'une résine de protection sur la puce câblée et le report, sur la résine de protection, d'une pastille de renfort dont la surface délimite le contour final du dispositif électronique. Cet assemblage est réalisé sur un support particulier où d'éventuels contacts, ou pistes de circuit ou interfaces d'alimentation et/ou communication, vont se détacher du support et être transférés dans la résine de protection de la puce pour former les contacts externes d'une carte à puce par exemple. Pour cela, le support présente une faible adhésion, ou une adhésion pouvant être altérée ultérieurement pour permettre sa séparation.

A cet effet, l'invention a pour objet un procédé de fabrication d'un dispositif électronique comprenant au moins un composant électronique, ledit procédé comprenant une étape de report dudit composant électronique sur une face d'un support diélectrique amovible, et étant caractérisé en ce qu'il comprend en outre les étapes suivantes :
- dispense d'une résine de protection sur ledit composant électronique,
- report, sur la résine de protection, d'une pastille de renfort dont la surface délimite le contour final dudit dispositif électronique, la résine de protection se répartissant, sous l'action du poids de la pastille, jusqu'audit contour dudit dispositif électronique pour former ses bords latéraux et lui conférer son épaisseur finale.

Ainsi, le procédé de fabrication est très simple et permet de supprimer un certain nombre d'étapes conventionnelles dans la fabrication des cartes à puce. Les étapes d'injection du corps de carte ou de moulage ou surmoulage du corps de carte notamment, ainsi que les étapes de laminage d'adhésif sur la bande de modules, puis de découpe et d'insertion du module électronique dans une cavité du corps de carte ne sont plus nécessaires. De même, l'étape de dépluggage consistant à détacher une carte d'un format réduit d'un corps de carte de plus grande taille, tel que le détachement d'une carte SIM au format 2FF, ou 3FF ou 4FF d'un corps de carte de plus grand format respectivement 1 FF, 2FF ou 3FF, n'est plus nécessaire. Grâce au procédé selon l'invention, le module et le corps du dispositif électronique sont réalisés simultanément au moment des étapes d'enrobage de composant(s) et de report de la pastille de renfort. Ce procédé permet en outre l'obtention de dispositifs d'épaisseur réduite.

Selon d'autres caractéristiques optionnelles du procédé :
- le procédé comprend en outre, préalablement au report dudit composant électronique, une étape de fourniture et réalisation d'au moins un jeu de métallisations conductrices sur la face du support diélectrique amovible, ledit composant électronique étant ensuite reporté et connecté électriquement audit jeu de métallisations conductrices, et en ce que la résine de protection adhère audit jeu de métallisations avec une force supérieure à l'adhésion du support diélectrique amovible,
- ultérieurement au report de la pastille, la résine de protection est durcie par apport de chaleur ou par insolation sous rayonnement UV,
- le support diélectrique amovible est chauffé à une température inférieure à la température de polymérisation de la résine de manière à fluidifier cette dernière et favoriser sa répartition jusqu'au contour du dispositif électronique,
- le procédé consiste en outre à prévoir un moyen d'arrêt de la résine de protection, ledit moyen d'arrêt s'étendant le long dudit contour final du dispositif électronique et étant disposé sur la pastille de renfort et/ou sur le support diélectrique amovible,
- le moyen d'arrêt est formé d'un contour métallique gravé sur le support amovible, ledit contour métallique présentant une largeur suffisante pour permettre l'obtention d'une adhérence dudit contour métallique plus forte sur le support amovible que sur la résine de protection,
- le contour métallique gravé sur le support amovible est réalisé simultanément à la réalisation du jeu de métallisations,
- le moyen d'arrêt forme une surépaisseur et est réalisé par apport de matière sur le support diélectrique amovible et /ou sur la pastille,
- le support diélectrique amovible est retiré des métallisations et de la résine de protection, ou détruit ou altéré au niveau de son adhésion notamment par apport de chaleur,
- le support diélectrique amovible comprend une pluralité de zones de réception de dispositifs électroniques et constitue un moyen de conditionnement d'une pluralité de dispositifs électroniques.

L'invention a également pour objet un dispositif électronique comprenant au moins un composant électronique enrobé dans une résine de protection sur laquelle repose une pastille de renfort, ledit dispositif électronique étant caractérisé en ce qu'il comprend une première face formée et délimitée par ladite pastille de renfort et en ce que ses bords latéraux sont formés et délimités par ladite résine de protection.

Selon d'autres caractéristiques optionnelles du dispositif :
- le dispositif comprend une deuxième face, opposée à la première face formée par la pastille de renfort, ladite deuxième face étant formée et délimitée par ladite résine de protection,
- le dispositif comprend en outre un jeu de métallisations électriquement connecté audit composant électronique, ledit jeu de métallisations étant supporté par la deuxième face formée par ladite résine de protection,
- la surface externe des métallisations est au même niveau ou sensiblement au même niveau que la surface externe de la résine de protection,
- la pastille de renfort comprend le long de son pourtour une surépaisseur dont la hauteur est égale à toute ou partie de l'épaisseur du corps du dispositif,
- l'épaisseur de la pastille est comprise entre 50 et 300µm,
- le dispositif est obtenu par le procédé décrit ci-dessus.

L'invention porte enfin sur un support notamment bobiné comprenant une pluralité de zones accueillant chacune un dispositif électronique tel que décrit ci-dessus, fabriqué selon le procédé de fabrication décrit ci-dessus, chaque dispositif électronique pouvant être détaché dudit support par retrait du support, ou destruction ou altération de son adhésion notamment par apport de chaleur.

### [Brève description des figures]

D'autres particularités et avantages de l'invention apparaitront à la lecture de la description suivante faite à titre d'exemple illustratif et non limitatif, en référence aux Figures annexées qui représentent :
- Les Figures 1 à 6, les différentes étapes d'un procédé de fabrication d'un dispositif électronique selon l'invention ;
- Les Figures 7 à 10, les différents modes de séparation du support amovible sur lequel est fabriqué et conditionné le dispositif électronique ;
- La Figure 11, les différentes vues de dispositifs électroniques selon l'invention.

### [Description]

Le dispositif électronique selon l'invention comprend au moins un composant électronique relié à une interface de communication. Le composant électronique peut par exemple se présenter sous forme d'une puce de circuit intégré et/ou d'une diode par exemple. L'interface de communication peut prendre différentes formes selon l'application à laquelle est destiné le dispositif. Elle peut par exemple se présenter sous forme de contacts affleurant la surface externe du dispositif, ou sous forme d'antenne bobinée affleurant la surface ou noyée dans le corps du dispositif. Elle peut également se présenter sous forme de plaques, agissant par exemple comme capteur capacitif, noyées dans le corps du dispositif.

Lorsque le dispositif comprend un jeu de métallisations affleurant sa surface externe, le procédé comporte une étape préalable de fourniture ou de réalisation d'au moins un jeu de métallisations, comprenant des plages ou pistes de circuit conductrices réalisant une interface de communication et/ou d'alimentation notamment à contacts électriques et/ou à antenne radiofréquence, sur un support adhésif ou de faible adhésivité.

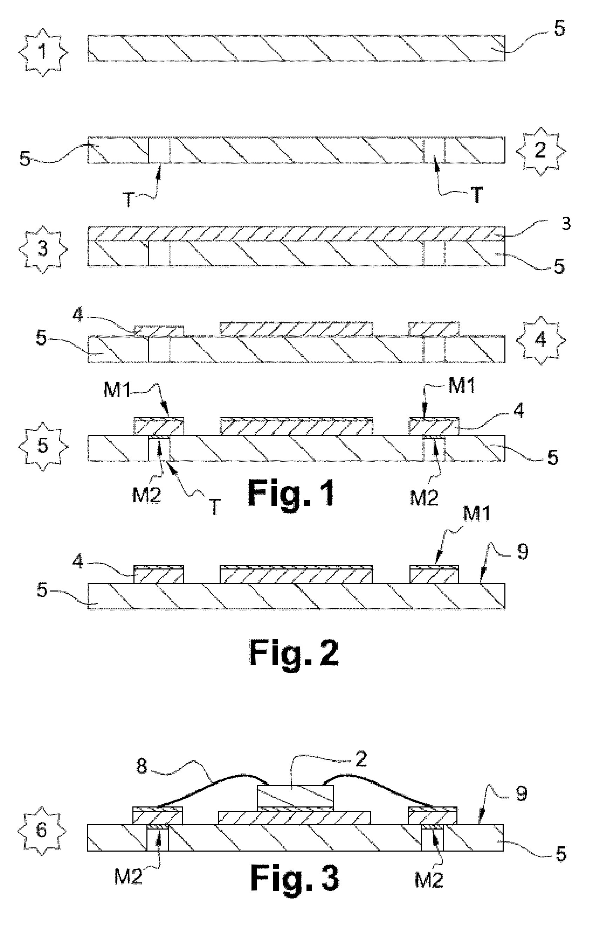

La Figure 1 illustre les différentes étapes 1 à 5 permettant de réaliser au moins un jeu de métallisations 4 comprenant des contacts en cuivre sur un substrat 5 amovible, c'est-à-dire un substrat détachable. Le substrat 5, encore dénommé support dans la suite de la description, est un film diélectrique choisi pour ses propriétés de faible adhésion, de façon à ce que la résine de protection ultérieurement dispensée à sa surface se détache facilement. Le matériau de constitution d'un tel support peut par exemple être choisi parmi des polymères tels que du PET (polyéthylène téréphtalate), du PEN (Polyéthylène naphthalate), ou encore un matériau peu cher du type papier.

Dans le cas d'une antenne, celle-ci peut être réalisée à plat sous forme de spirale. La description est faite préférentiellement pour des métallisations à contacts électriques, mais l'invention peut s'appliquer également à d'autres éléments conducteurs électriques tels que des plaques, des pistes ou antennes par exemple. Ainsi, dans toute la description, l'interface à contacts 4 peut être remplacée par une interface radiofréquence à antenne.

De préférence, le support 5 est déterminé avec une pluralité de zones destinées à recevoir chacune un corps de dispositif électronique. Lorsque le dispositif est destiné à présenter des métallisations en surface, les zones de réception du support 5 sont également destinées à recevoir un jeu de métallisations 4.

Dans le cas où les métallisations de surface sont réalisées à l'aide d'un procédé faisant intervenir des pistes d'amenées de courant, on prendra soin à ce que ces pistes soient peu nombreuses et aient une configuration facilitant leur séparation, lors de la séparation des dispositifs électroniques obtenus et du support de faible adhésivité, par exemple en ayant une forme de striction, ou prédécoupe ou réduction de section à l'endroit où elles doivent être sectionnées. Aussi, celles-ci peuvent être supprimées par gravure ou coupées localement par laser ou tout autre procédé équivalent.

Une première étape 1 consiste donc à fournir un diélectrique 5, de préférence revêtu d'un adhésif de faible adhésivité et formant ainsi le support 5 amovible. L'adhésif peut être peu adhérent de par sa nature ou dégradable à la chaleur ou dégradable aux UV (ultraviolets) ou dégradable aux IR (infrarouges), de façon à ce que chaque jeu de métallisations 4, notamment en cuivre, et la résine de protection 7 ultérieurement déposés à sa surface, se détachent facilement. Les valeurs de faible adhésivité pour que les métallisations 4 et la résine de protection 7 puissent se détacher du support 5 peuvent être typiquement comprises entre 0,5 et 5 Newton /cm au test de résistance au pelage à 90 degrés. La vitesse de pelage peut être par exemple de 30 cm / minute ou plus.

Le support 5 est ensuite percé, notamment par poinçonnage, tel qu'illustré à l'étape 2. Les trous T obtenus permettront ultérieurement de réaliser un traitement de surface des métallisations 4. Ces trous permettent également de faciliter la séparation du support amovible 5 et du dispositif électronique obtenu.

A l'étape 3, on effectue une fixation provisoire, notamment par lamination, d'une feuille conductrice 3, notamment en cuivre, sur le support diélectrique 5 amovible. L'étape suivante 4 consiste ensuite à effectuer une gravure chimique de la feuille conductrice 3 pour réaliser la forme souhaitée des contacts externes 4 pour le dispositif électronique en fabrication.

A l'étape 5, un traitement de surface M1, M2 des parties en cuivre est préférentiellement effectué. Ce traitement des métallisations 4 consiste à rajouter une couche de métallisation additionnelle, de type Ni / Pd/ Au (Nickel/ Palladium /Or) par exemple, formant une couche de passivation M1 et/ou M2 sur les contacts 4. Ce traitement peut se faire sur les deux faces de la feuille de cuivre gravée. La face en contact avec le support 5 amovible peut en effet être également traitée en surface à travers les trous T préalablement percés dans le support amovible 5. Ainsi, les contacts externes 4 destinés à affleurer sensiblement la surface externe du dispositif électronique, à l'épaisseur de la couche de traitement M2 près ou de la couche d'adhésif du support amovible 5, sont également traités.

Selon une variante de mise en oeuvre, le support amovible 5 ci-dessus peut être non poinçonné, comme illustré à la Figure 2. Dans ce cas, les contacts externes 4 peuvent rester en cuivre et être éventuellement protégés de l'oxydation par une passivation organique ou autre traitement de surface préalable ou ultérieur.

Selon une autre variante de mise en oeuvre, le substrat ci-dessus peut être poinçonné, comme illustré à la Figure 1, d'un nombre de trous T supérieur à ceux nécessaires pour le traitement par métallisation M2 des contacts 4, ceci afin d'améliorer la séparation ultérieure entre le support amovible 5 et le dispositif électronique obtenu, la surface en vis-à-vis étant en effet plus faible.

Alternativement, les plages de contact 4 peuvent être perforées pour limiter l'adhésion et pour économiser les métallisations et/ou permettre une perméabilité électromagnétique dans le cas où l'objet comprend également une antenne radiofréquence, par exemple gravée sur le support.

Le cas échéant, on réalise une antenne (non représentée) par exemple au même niveau que les contacts ou pistes conductrices, notamment en périphérie et/ou dans une zone centrale par rapport aux plages de contacts 4.

Selon une alternative à l'opération de gravure préférée dans l'invention, on peut prévoir de fixer ou d'imprimer une grille conductrice électriquement, notamment par jet de matière conductrice, sur le support 5 amovible pour former des contacts électriques 4 et/ou des pistes et/ou au moins une antenne.

A l'étape 6 (Fig. 3), on procède au report d'une puce électronique 2 de circuit intégré sur la face 9 du support amovible 5 comprenant les métallisations 4. Elle peut aussi être reportée directement sur ces éléments conducteurs (plages, pistes, spires d'antenne). La puce 2 est alors connectée aux contacts métalliques 4 par connexion filaires 8 par exemple. Après cette fixation de la puce, notamment par collage, on peut éventuellement utiliser un plasma de nettoyage pour améliorer l'adhésion de la résine de protection 7, ultérieurement dispensée, sur les contacts 4 métallisés. Dans une variante de réalisation, la connexion électrique de la puce 2 de circuit intégré avec les contacts 4 peut également être réalisée par la technique connue de « flip chip », ou puce retournée.

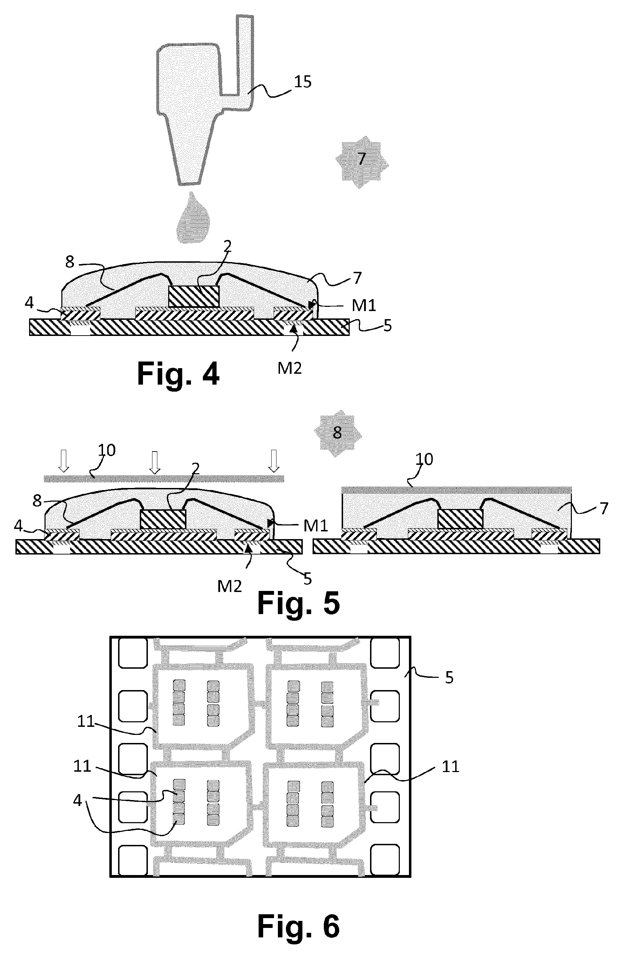

A l'étape 7 (Fig. 4), on procède à la dispense d'une résine isolante de protection 7 pour enrober la puce ainsi que ses connexions 8 (fils), au moyen d'un équipement 15 de dispense classiquement utilisé dans le domaine de la carte à puce.

De préférence, on prévoit une adhésion des métallisations 4 qui soit plus importante au contact de la résine de protection 7 qu'au contact du support amovible 5. Cette adhésion peut en outre être améliorée par différents procédés connus, tels que par exemple par augmentation de la rugosité du cuivre des contacts 4, par l'augmentation de la rugosité de surface (la métallisation additionnelle M1, M2, de type Ni /Pd /Au suit alors cette rugosité), par plasma de nettoyage avant dispense de la résine de protection, par points d'ancrage de la résine de protection dans des parties conductrices des métallisations.

A l'étape 8 (Fig. 5), on reporte une pastille de renfort 10 découpée à la taille finale du dispositif. Cette pastille présente notamment une surface délimitant le contour final du dispositif électronique. Ainsi, la pastille est reportée sur la résine de protection 7 alors que cette-dernière n'est pas durcie. Cette pastille de renfort 10 permet non seulement de rigidifier et protéger mécaniquement le dispositif électronique, mais aussi d'obtenir un dispositif électronique géométriquement homogène, en présentant notamment une surface plane. Cette pastille de renfort est avantageusement conditionnée en rouleau et est découpée à la taille finale du dispositif.

Selon une variante de réalisation, la pastille 10 peut aussi être formée en série, par moulage par exemple, et conditionnée sur des supports amovibles faiblement adhésifs par exemple.

La pastille est placée sur la résine de protection au moyen d'un équipement de report automatique classiquement utilisé dans les procédés de fabrication de cartes.

Cette pastille peut par exemple présenter une décoration, réalisée par impression, par tampographie ou tout autre procédé équivalent, sur sa surface plane destinée à former une surface externe opposée à celle supportant les contacts métalliques 4. La surface supportant les contacts métalliques 4 est elle-même formée par la résine de protection 7.

La pastille 10 se positionne sur le haut des fils de connexions 8. Sous l'action du poids de la pastille 10, la résine de protection 7 se répartie par capillarité jusqu'aux contours du dispositif pour former ses bords latéraux et lui conférer son épaisseur finale.

La nature de la pastille peut être un composite tel qu'un verre époxy ou un polymère thermoplastique tel qu'un PET (polyétylène téréphtalate), PEN (polyéthylène naphtalate), PC (polycarbonate) etc... L'épaisseur typique de la pastille peut varier de 50µm à 300µm selon sa matière, l'espace que l'on veut laisser à la puce et ses connexions et l'épaisseur souhaitée du dispositif électronique final.

La résine de protection peut être une résine à polymérisation thermique ou à polymérisation UV. De manière préférée, la résine est durcie par insolation sous rayonnement UV. Une telle résine présente en effet des avantages intéressants. En particulier, du fait du faible apport thermique d'une telle polymérisation, des supports 5 amovibles peu coûteux et supportant mal la température peuvent être utilisés. De plus le dispositif électronique ne risque pas d'être déformé du fait de dilatations différentielles trop importantes entre les différents matériaux. Enfin, l'insolation UV peut être réalisée à travers la pastille 10, lorsque son matériau de constitution est choisi pour laisser passer les longueurs d'onde UV, comme à travers le support amovible 5 lorsqu'il est réalisé dans un matériau transparent aux UV.

L'épaisseur de la résine varie selon l'épaisseur du dispositif final à réaliser et selon l'épaisseur de la pastille de renfort. Pour une carte nano-SIM, encore notée sous le sigle 4FF, dont l'épaisseur est normalisée à 0,67mm, par exemple, l'épaisseur de la résine entre la surface interne de la pastille de renfort 10 et la surface interne du support amovible 5 sera comprise entre 300 et 600µm.

Selon une variante de réalisation, le support diélectrique 5 amovible est chauffé à une température modérée, c'est-à-dire à une température inférieure à la température de polymérisation de la résine 7, lorsque celle-ci est polymérisable à chaud, de manière à fluidifier cette dernière et favoriser sa répartition jusqu'au contour du dispositif électronique.

La pastille peut être de couleur, ou teintée dans la masse. Ainsi, lorsque la résine de protection 7 est transparente, la face autour des contacts 4 apparait colorée.

De manière facultative, il est possible de prévoir un moyen d'arrêt apte à éviter le fluage de la résine de protection 7 et l'apparition de bavures sur le dispositif final. Ce moyen d'arrêt s'étend le long du contour du dispositif final et est disposé sur le support amovible 5 et /ou sur le contour de la pastille de renfort 10. Un tel moyen d'arrêt a pour fonction d'arrêter le fluage de la résine de protection, afin de conférer au dispositif électronique final des bords parfaitement rectilignes au moment du détachement du support amovible 5.

Sur le support amovible 5 tel qu'illustré sur la Figure 6, ce moyen d'arrêt peut être réalisé soit par gravure métallique du contour, soit par apport de matière. Ainsi, lorsqu'il est réalisé par gravure métallique par exemple, il peut avantageusement se présenter sous forme d'un contour métallique gravé dans la feuille métallique 3, fixée provisoirement sur le support amovible 5, simultanément à la réalisation des contacts 4 du futur dispositif électronique sur le support amovible. Un tel contour métallique gravé est représenté sur la Figure 6 sous la référence 11. Dans ce cas, ce contour métallique est réalisé sur une largeur suffisante pour que le métal de constitution adhère plus au support amovible 5 qu'au fin cordon de résine de protection pouvant éventuellement fluer à sa surface. Ainsi, au moment de la séparation du support amovible 5, le contour métallique 11 et le fin cordon de résine ayant éventuellement flué sur sa surface ne se délaminent pas en même temps que les contacts 4 et adhèrent toujours au support 5 amovible.

Pour prévenir encore mieux sa délamination et éviter que le contour métallique 11 ne vienne avec le dispositif lors de son détachement, le contour métallique 11 peut également être accroché par de nombreuses amenées de courant qui le retiennent. Aussi, toujours dans le même but, ce contour métallique 11 peut être étendu sur une grande partie du support 5 amovible voir jusqu'à son bord. Il peut aussi être retenu par plaquage d'une pièce contre le contour au moment du détachement du support 5 amovible.

Ce contour métallique 11 pouvant être de grande surface, il sera préférentiellement métallisé par la technique de « spot plating » consistant à effectuer un dépôt électrolytique dans des zones localisées de surfaces réduites et préférentielles (procédé de sélectivité). Un tel dépôt de métal permet de réduire les quantités de métal utilisées et d'éviter l'utilisation de métal précieux tel que l'or. Le contour métallique peut par exemple être réalisé en cuivre-nickel.

Selon une autre variante de réalisation, le moyen d'arrêt peut par exemple être réalisé par apport de matière. Cet apport de matière peut être réalisé sur le contour de la face de la pastille 10 destinée à reposer sur la résine de protection 7, ou sur le support amovible le long du contour final du dispositif. Cet apport de matière peut être réalisé par impression de matière ou encore par dispense d'un matériau élastomère tel qu'un silicone par exemple. Il forme ainsi un rebord ou une surépaisseur.

Le moyen d'arrêt peut également faire partie intégrante de la pastille 10 lorsque celle-ci est réalisée par une technique de moulage par exemple.

Dans ce cas, la hauteur du moyen d'arrêt, ou rebord, est égale à toute ou partie de l'épaisseur finale du dispositif.

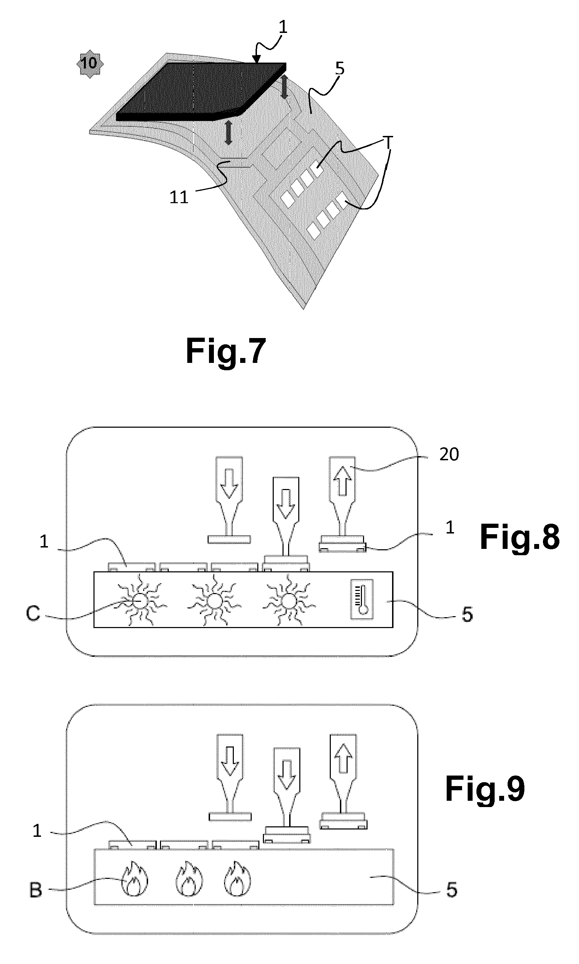

A l'étape 10 (Fig.7), on procède ensuite à une séparation du dispositif électronique obtenu 1, dont les contacts 4 adhérent à la résine de protection 7, du support amovible 5. Cette séparation peut être réalisée de différentes manières.

De préférence, le support 5 est déterminé avec une pluralité de zones de réception de dispositifs pour réaliser une pluralité de dispositifs en série, qui sont conditionnés sur le support amovible 5, qui peut lui-même être bobiné par exemple. Lors de la séparation du support amovible 5, le dispositif électronique 1 se détache et ne restent sur le support 5 que les trous T préalablement poinçonnés sur le support 5 et le moyen d'arrêt 11 de la résine éventuellement ménagé le long du pourtour extérieur du dispositif 1.

On peut alors procéder, sur un tel support 5, à une saisie des dispositifs notamment par ventouses (Fig. 8) disposées sur des préhenseurs mobiles 20 robotisés après avoir chauffé « C » le support 5, notamment par lampes à infrarouge, pour dégrader l'adhésion de l'adhésif maintenant provisoirement les dispositifs 1 sur le support 5 et permettre ainsi la séparation du dispositif 1 avec son jeu de métallisations (contacts, pistes), par rapport au support 5. L'adhésif peut être un adhésif thermoplastique ou thermo fusible.

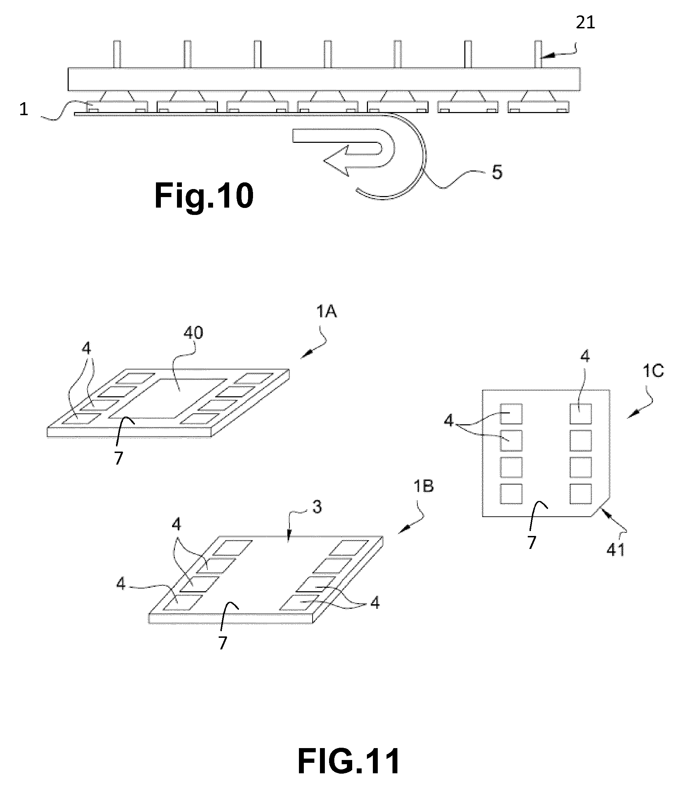

En alternative (Fig. 9), on peut effectuer une destruction du support notamment par brûlage « B », comme dans le cas d'un support 5 en papier par exemple. On peut également effectuer une séparation des dispositifs 1 individuels par pelage du substrat 5 (Fig. 10), les boitiers étant maintenus par aspiration sur des buses 21.

A la Figure 11, les dispositifs électroniques 1A à 1C obtenus ont ici la forme de mini cartes 1A, 1 B, 1C à contacts électriques 4 affleurant leur surface principale. La résine de protection 7, constituant le corps isolant de la mini carte, comprend une face 3 pouvant se situer au même niveau que les plages de contact 4. Autrement dit, les différentes métallisations 4 sont espacées de matière isolante, c'est-à-dire de la résine de protection 7, et affleurent sensiblement la face externe 3 du dispositif formée par la résine de protection 7. Le cas échéant, selon les variantes de traitement de surface, il peut y avoir une légère différence de niveau entre les métallisations 4 et la résine de protection 7. En effet, si le support 5 amovible comporte ou non une couche d'adhésif, la couche de métallisation M2 du traitement de surface située dans le trou T du support amovible 5, à distinguer de la métallisation 4 du support, peut avoir un niveau supérieur au niveau de la face externe 3 de la résine de protection 7. Selon l'épaisseur déposée de la métallisation M2 de traitement, les plages de contact 4 du dispositif 1 peuvent affleurer la surface principale 3 de la résine de protection 7, d'une valeur comprise entre 0µm et de préférence 25µm, voire 50 µm.

L'objet 1A peut comporter, au centre, une zone 40 pour une métallisation quelconque (contact, antenne...). L'objet 1 B est parallélépipédique et l'objet 1C comprend un détrompeur 41 en plus du précédent.

Grâce à l'invention, on peut agencer des composants électriques / électroniques ou des métallisations 4 du dispositif électronique, avant l'étape d'enrobage, de manière que la surface externe des composants soit au même niveau, ou sensiblement au même niveau, que la surface externe 3 de la résine de protection 7 dispensée au moment de l'étape d'enrobage.

Grâce à l'invention on peut ainsi réduire au maximum l'épaisseur des dispositifs électroniques. La puce peut être placée directement sur une des métallisations 4 ou directement sur le support amovible 5. Le nombre d'éléments superposés et constituant le dispositif électronique est réduit. En particulier, les dispositifs électroniques réalisés selon l'invention ne comprennent plus de film support diélectrique dans leur constitution finale. Les étapes de procédé sont moins nombreuses, les étapes de surmoulage d'un corps de dispositif étant notamment supprimées. Le report de la pastille 10 au format final du dispositif électronique, sur la résine de protection 7, permet de réaliser en une seule étape l'encapsulation de la puce et de ses connexions, et la réalisation du corps du dispositif électronique final.

Dans une autre variante, concernant la fixation de la puce, celle-ci peut être collée directement sur la face 9 du support amovible 5 de faible adhésivité, contrairement à la Figure 3. Ainsi après retrait du support 5, la colle de fixation de la puce est au même niveau que la face externe 3 de la résine de protection 7 du dispositif électronique 1, ou sensiblement au même niveau que les métallisations 4.

Dans une autre alternative, on peut même pousser la diminution de l'épaisseur du dispositif à son maximum en déposant la puce 2 directement sur le support 5 de faible adhésivité ou un support 5 enduit d'un adhésif décrit précédemment. Ainsi après retrait du support 5, la face arrière de la puce 2 se retrouve en surface 3 du dispositif électronique 1.

Le cas échéant, un composant électronique comme un capteur d'empreinte peut venir en surface de la face 3 du dispositif électronique car monté comme la puce 2, directement contre la surface 9 du support amovible 5. Ainsi, un composant, tel qu'une puce électronique ou élément réalisant une fonction de capteur d'empreinte, peut être monté de manière à offrir une surface plane affleurant la surface externe 3 du dispositif électronique.

Cette invention permet aussi de réduire l'épaisseur des cartes SIM si besoin car, seuls les contacts ou métallisations utiles sont conservés, après transferts de ceux-ci dans la résine de protection et séparation de l'épaisseur de support amovible. De plus les contacts sont intégrés dans la résine de protection et présentent très peu, ou pas, de surépaisseur. Le procédé de fabrication des dispositifs électroniques selon l'invention présente un nombre réduit d'étapes, ce qui se traduit par une réduction en termes de coûts.

## Revendications

1. Procédé de fabrication d'un dispositif électronique (1) comprenant au moins un composant électronique (2), ledit procédé comprenant une étape de report dudit composant électronique (2) sur une face (9) d'un support diélectrique (5) amovible, et étant **caractérisé en ce qu'**il comprend en outre les étapes suivantes :
- dispense d'une résine de protection (7) sur ledit composant électronique,
- report, sur la résine de protection (7), d'une pastille (10) de renfort dont la surface délimite le contour final dudit dispositif électronique (1), la résine de protection (7) se répartissant sous la pastille (10), jusqu'audit contour dudit dispositif électronique (1) pour former ses bords latéraux et lui conférer son épaisseur finale.

2. Procédé de fabrication selon la revendication 1, **caractérisé en ce qu'**il comprend en outre, préalablement au report dudit composant électronique (2), une étape de fourniture et réalisation d'au moins un jeu de métallisations (4) conductrices sur la face (9) du support diélectrique (5) amovible, ledit composant électronique étant ensuite reporté et connecté électriquement audit jeu de métallisations conductrices, et **en ce que** la résine de protection (7) adhère audit jeu de métallisations (4) avec une force supérieure à l'adhésion du support diélectrique (5) amovible.

3. Procédé selon l'une des revendications 1 à 2, **caractérisé en ce que** ultérieurement au report de la pastille, la résine de protection est durcie par apport de chaleur ou par insolation sous rayonnement UV.

4. Procédé selon l'une des revendications 1 à 3, **caractérisé en ce que** le support diélectrique (5) amovible est chauffé à une température inférieure à la température de polymérisation de la résine (7) de manière à fluidifier cette dernière et favoriser sa répartition jusqu'au contour du dispositif électronique.

5. Procédé selon l'une des revendications 1 à 4, **caractérisé en ce qu'**il consiste en outre à prévoir un moyen d'arrêt de la résine de protection, ledit moyen d'arrêt s'étendant le long dudit contour final du dispositif électronique et étant disposé sur la pastille de renfort (10) et/ou sur le support diélectrique (5) amovible.

6. Procédé selon la revendication 5, **caractérisé en ce que** le moyen d'arrêt est formé d'un contour métallique gravé (11) sur le support (5) amovible, ledit contour métallique (11) présentant une largeur suffisante pour permettre l'obtention d'une adhérence dudit contour métallique (11) plus forte sur le support amovible (5) que sur la résine de protection (7).

7. Procédé selon la revendication 6, **caractérisé en ce que** le contour métallique gravé (11) sur le support (5) amovible est réalisé simultanément à la réalisation du jeu de métallisations (4).

8. Procédé selon la revendication 5, **caractérisé en ce que** le moyen d'arrêt forme une surépaisseur et est réalisé par apport de matière sur le support diélectrique (5) amovible et /ou sur la pastille (10).

9. Procédé selon l'une quelconque des revendications précédentes, **caractérisé en ce que** le support diélectrique (5) amovible est retiré des métallisations (4) et de la résine de protection (7), ou détruit ou altéré au niveau de son adhésion notamment par apport de chaleur.

10. Procédé selon l'une quelconque des revendications précédentes, **caractérisé en ce que** le support diélectrique (5) amovible comprend une pluralité de zones de réception de dispositifs électroniques (1) et constitue un moyen de conditionnement d'une pluralité de dispositifs électroniques.

11. Dispositif électronique (1) comprenant au moins un composant électronique (2) enrobé dans une résine de protection (7) sur laquelle repose une pastille de renfort (10), ledit dispositif électronique étant **caractérisé en ce qu'**il comprend une première face formée et délimitée par ladite pastille de renfort (10) et **en ce que** ses bords latéraux sont formés et délimités par ladite résine de protection (7).

12. Dispositif électronique selon la revendication 11, **caractérisé en ce qu'**il comprend une deuxième face, opposée à la première face formée par la pastille de renfort (10), ladite deuxième face étant formée et délimitée par ladite résine de protection (7).

13. Dispositif électronique selon la revendication 12, **caractérisé en ce qu'**il comprend en outre un jeu de métallisations (4) électriquement connecté audit composant électronique (2), ledit jeu de métallisations étant supporté par la deuxième face formée par ladite résine de protection (7).

14. Dispositif électronique selon la revendication 13, **caractérisé en ce que** la surface externe des métallisations (4) est au même niveau ou sensiblement au même niveau que la surface externe (3) de la résine de protection (7).

15. Dispositif électronique selon l'une des revendications 11 à 14, **caractérisé en ce que** la pastille de renfort (10) comprend, le long de son pourtour, une surépaisseur dont la hauteur est égale à toute ou partie de l'épaisseur du corps du dispositif.

16. Dispositif électronique selon l'une des revendications 11 à 15, **caractérisé en ce que** l'épaisseur de la pastille est comprise entre 50 et 300µm.

17. Dispositif électronique selon l'une des revendications 11 à 16, caractérisé en ce qu"il est obtenu par le procédé selon l'une des revendications 1 à 10.

18. Support (5) notamment bobiné comprenant une pluralité de zones accueillant chacune un dispositif électronique (1) selon l'une des revendications 11 à 17, fabriqué selon le procédé de fabrication conforme aux revendications 1 à 10, chaque dispositif électronique (1) pouvant être détaché dudit support (5) par retrait du support, ou destruction ou altération de son adhésion notamment par apport de chaleur.
